# EUROPÄISCHE PATENTANMELDUNG

(11) **EP 1 465 199 A2**
(43) Veröffentlichungstag der Anmeldung: **06.10.2004**
(21) Anmeldenummer: 04012400.0
(22) Anmeldetag: 03.11.2000
(51) Int. Cl.: G11C 8/12, G11C 8/10

(54) **Speichereinrichtung**

(30) Priorität: 19.11.1999 DE 19955779
(62) Teilanmeldung aus: 00979447.0
(71) Anmelder: Infineon Technologies AG, 81669 München (DE)
(72) Erfinder: Paul, Steffen, 82065 Baierbrunn (DE); Seifert, Martin, 81541 München (DE)
(74) Vertreter: Repkow, Ines, Dr. Dipl.-Ing.

(57) **Zusammenfassung**

Es wird eine Speichereinrichtung beschrieben, mit einer Vielzahl von Speicherzellen zum Speichern von Daten, und mit einer zwei oder mehrere miteinander kooperierende Decodier-Einheiten aufweisenden Decodiereinrichtung zur Auswahl der auszulesenden oder zu beschreibenden Speicherzelle(n). Die beschriebene Speichereinrichtung zeichnet sich dadurch aus, daß die Decodier-Einheiten, die von anderen Decodier-Einheiten Daten oder Signale übermittelt bekommen, zumindest teilweise mit einem Leseverstärker zur Entgegennahme, Auswertung und/oder Weiterleitung dieser Daten oder Signale ausgestattet sind.

## Beschreibung

Die vorliegende Erfindung betrifft eine Vorrichtung gemäß dem Oberbegriff des Anspruchs 1.

Speichereinrichtungen dieser Art sind insbesondere Halbleiterspeicher wie beispielsweise RAMs, ROMs, EPROMs, EEPROMs, Flash-Speicher etc. Solche Speichereinrichtungen sind seit vielen Jahren in unzähligen Ausführungsformen bekannt und bedürfen keiner näheren Erläuterung.

Derartige und andere Speichereinrichtungen sollen nach Möglichkeit immer schneller arbeiten und dabei immer weniger Chipfläche beanspruchen und immer weniger Energie verbrauchen.

Hierfür wurden unter anderem bereits diverse Verbesserungen an der zur Auswahl der auszulesenden oder zu beschreibenden Speicherzelle(n) vorgesehenen Decodiereinrichtung vorgenommen.

Diese Verbesserungen bestehen unter anderem darin, daß die Decodiereinrichtung, genauer gesagt der zur Speicherzellenzeilen-Auswahl dienende Teil derselben, einen sogenannten Predecoder und eine Vielzahl sogenannter Postdecoder aufweist, wobei der Predecoder eine Vordecodierung vornimmt, in welcher "nur" festgelegt wird, in welchem (mehrere Speicherzellenzeilen umfassenden) Speicherzellenzeilen-Bereich die auszulesenden oder zu beschreibenden Speicherzellen liegen, und wobei in den dem Predecoder nachgeschalteten, und jeweils einem bestimmten Speicherzellenzeilen-Bereich zugeordneten Postdecodern festgelegt wird, in welcher Speicherzellenzeile die auszulesenden oder zu beschreibenden Speicherzellen liegen. Durch eine solche Strukturierung der Decodiereinrichtung lassen sich die benötigte Chipfläche reduzieren und die Leistungsfähigkeit der Decodiereinrichtung steigern.

Hieredurch konnten Speicherbausteine entwickelt werden, die kleiner sind, mit weniger Energie auskommen, und schneller arbeiten als es vorher der Fall war.

Allerdings hat sich mittlerweile herausgestellt, daß dies nicht immer und überall der Fall ist. Unter gewissen Umständen lassen sich die vorstehend genannten Vorteile nicht erzielen und/oder arbeiten wie beschrieben ausgebildete Speicherbausteine unzuverlässig oder fehlerhaft.

Der vorliegenden Erfindung liegt daher die Aufgabe zugrunde, die Speichereinrichtung gemäß dem Oberbegriff des Anspruchs 1 derart weiterzubilden, daß diese unter allen Umständen klein realisierbar ist, einen geringen Energiebedarf hat, und zuverlässig und schnell arbeitet.

Diese Aufgabe wird erfindungsgemäß durch die in Anspruch 1 beanspruchte Speichereinrichtung gelöst.

Der Einsatz des Leseverstärkers ermöglicht es, daß auch nur kurzzeitig fließende und/oder sehr kleine Ströme zwischen den miteinander kooperierenden Decodier-Einheiten zuverlässig erkannt werden können.

Der Wegfall der Notwendigkeit, daß zu erfassende Ströme relativ lange fließen müssen und/oder relativ groß sein müssen, um zuverlässig erfaßt zu werden, ermöglicht die Realisierung von Speichereinrichtungen, die eine besonders geringe Größe aufweisen, einen geringen Energiebedarf haben, und dennoch äußerst zuverlässig und sehr schnell arbeiten.

Vorteilhafte Weiterbildungen der Erfindung sind den Unteransprüchen, der nachfolgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: schematisch den Aufbau und die Verschaltung einer Speicherzelle und eines Leseverstärkers zum Auslesen des Speicherzelleninhaltes,
- Figuren: 2 bis 31 Darstellungen der nachfolgend näher beschriebenen Leseverstärker, und
- Figur 32: die nachfolgend näher beschriebene Decodiereinrichtung zur Auswahl der auszulesenden oder zu beschreibenden Speicherzelle(n).

Die nachfolgend näher beschriebene Speichereinrichtung ist ein SRAM. Die nachfolgend näher beschriebenen Besonderheiten der Speichereinrichtung können jedoch auch bei anderen Speicherbausteinen wie beispielsweise anderen RAMs, ROMs, EPROMs, EEPROMs, Flash-Speicher und dergleichen eingesetzt werden.

Die betrachtete Speichereinrichtung weist eine Vielzahl von Speicherzellen auf, die matrixartig in einer Vielzahl von Zeilen und einer Vielzahl von Spalten angeordnet sind.

Die betrachtete Speichereinrichtung ist in CMOS-Technik aufgebaut. Die nachfolgend näher beschriebenen Besonderheiten der betrachteten Speichereinrichtung sind jedoch - gegebenenfalls nach entsprechender Modifikation - auch bei nach anderen Techniken aufgebauten Speichereinrichtungen anwendbar.

Im betrachteten Beispiel sind pro Speicherzellenspalte zwei Bitleitungen vorhanden und überwachbar; auf den Bitleitungen stellen sich unterschiedliche Ströme und Spannungen ein. Der Leseverstärker, unter Verwendung dessen der Inhalt der auszulesenden Speicherzelle ermittelt wird, überwacht im betrachteten Beispiel beide Bitleitungen. Die nachfolgend näher beschriebenen Besonderheiten der betrachteten Speichereinrichtung sind jedoch - gegebenenfalls nach entsprechender Modifizierung - auch anwendbar, wenn nur eine Bitleitung vorhanden ist oder berücksichtigt wird.

Die jeweils auszulesende(n) oder zu beschreibende(n) Speicherzelle(n) der Speichereinrichtung werden durch eine an den Speicherbaustein angelegte Adresse definiert. Eine Decodiereinrichtung ermittelt aus dieser Adresse, welche Speicherzellen(n) durch diese bezeichnet werden. Nachdem dies geschehen ist, können die betreffenden Speicherzellen ausgelesen werden.

Der Leseverstärker, unter Verwendung dessen der Inhalt einer auszulesenden Speicherzelle ermittelt wird, ist im betrachteten Beispiel dazu ausgelegt, den Inhalt der auszulesenden Speicherzelle basierend auf der Größe und/oder der Richtung des Stromflusses festzulegen, der sich beim Auslesen der betreffenden Speicherzelle zwischen dieser und dem Leseverstärker (auf den der auszulesenden Speicherzelle zugeordneten Bitleitung) einstellt.

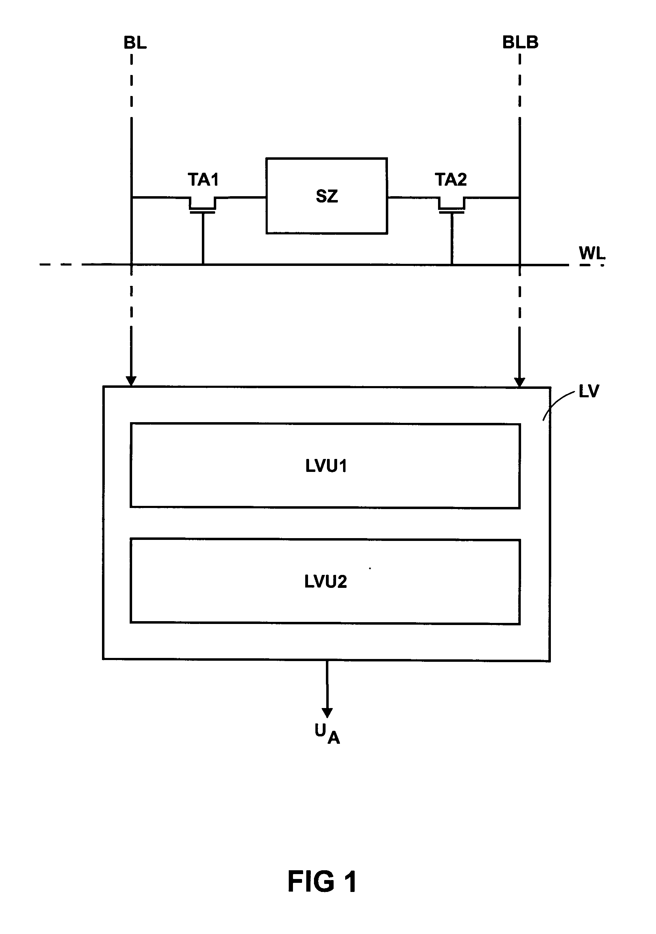

Figur 1 zeigt schematisch den Aufbau und die Verschaltung einer Speicherzelle und eines Leseverstärkers zum Auslesen des Speicherzelleninhalts.

Die Speicherzelle ist dabei mit dem Bezugszeichen SZ bezeichnet, und der Leseverstärker mit dem Bezugszeichen LV.

Die Speicherzelle SZ ist über Auswahltransistoren TA1 und TA2 und Bitleitungen BL und BLB mit dem Leseverstärker LV verbunden.

Die Auswahltransistoren TA1 und TA2 werden über eine zugeordnete Wortleitung WL angesteuert. Die Wortleitung WL ist mit allen Speicherzellen (genauer gesagt den diesen zugeordneten Auswahltransistoren) einer Speicherzellenzeile verbunden und wird von der vorstehend bereits erwähnten, aber in der Figur 1 nicht gezeigten Decodiereinrichtung mit einer Spannung beaufschlagt, durch die die Auswahltransistoren in den leitenden Zustand versetzt werden (wenn aus der betreffenden Speicherzellenzeile ein oder mehrere Speicherzellen ausgelesen werden sollen) oder durch die die Auswahltransistoren in den sperrenden Zustand versetzt werden (wenn aus der betreffenden Speicherzellenzeile keine Speicherzelle ausgelesen werden soll). Die Anordnung enthält ferner eine in der Figur 1 ebenfalls nicht gezeigte Spaltenauswahleinrichtung, durch welche festgelegt wird, von welcher Speicherzellen-Spalte die Bitleitungen BL und BLB durch den Leseverstärker LV überwacht werden sollen (welche Bitleitungen mit dem Leseverstärker verbunden werden).

Der Leseverstärker LV besteht im betrachteten Beispiel aus einer ersten Verstärkerstufe LVU1 und einer zweiten Verstärkerstufe LVU2.

Die erste Verstärkerstufe LVU1 ist ein Eingangsverstärker mit Impedanzwandler. Ihr, genauer gesagt dem Impedanzwandler derselben, obliegt es insbesondere, für einen möglichst geringen Eingangswiderstand des Leseverstärkers zu sorgen (damit die ohnehin schwachen Ströme auf den Bitleitungen ungehindert in den Leseverstärker gelangen können). Dabei kann es sich als vorteilhaft erweisen, wenn der Eingangswiderstand des Leseverstärkers negativ wird, denn dadurch können vorhandene Auswahltransistor- und Bitleitungs-Widerstände eliminiert werden, wodurch der Leseverstärker widerstandslos mit der auszulesenden Speicherzelle verbunden werden kann.

Die zweite Verstärkerstufe LVU2 erfaßt die auf den Bitleitungen BL und BLB fließenden Ströme, legt basierend darauf (vorzugsweise basierend auf der Differenz der Ströme) den Inhalt der betreffenden Speicherzelle fest und gibt ein den Inhalt repräsentierendes Signal U_{A} aus. Es handelt sich im betrachteten Beispiel also um einen Stromdifferenzverstärker mit I/U-Wandler.

Ein möglicher Aufbau eines solchen Leseverstärkers ist aus der US 5.253.137 bekannt. Der aus dieser Druckschrift bekannte Leseverstärker weist allerdings die eingangs erwähnten Nachteile auf.

Der im vorliegend betrachteten Speicherbaustein zum Einsatz kommende Leseverstärker unterscheidet sich hiervon. Er zeichnet sich dadurch aus, daß dessen Eingangswiderstand individuell einstellbar ist.

Wie nachfolgend im einzelnen beschrieben wird, läßt sich dies beispielsweise dadurch erreichen, daß der Leseverstärker eingangsseitig mit
- einem symmetrischen Gatestufenverstärker mit einstellbarer Spannungs-Rückkopplung oder Spannungs-Kreuzkopplung und/oder mit
- einem symmetrischen Gatestufenverstärker, dem eingangsseitig zwei Stromquellen zugeschaltet sind, die unter Verwendung von aus den Gatestufenverstärker-Zweigen abgegriffenen Spannungen variabel steuerbar sind,
versehen ist.

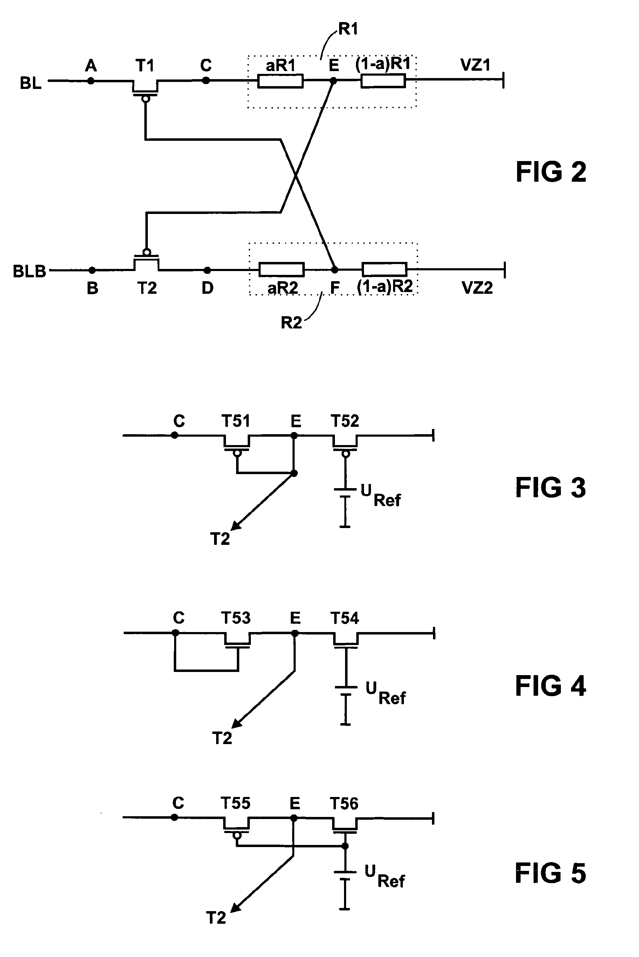

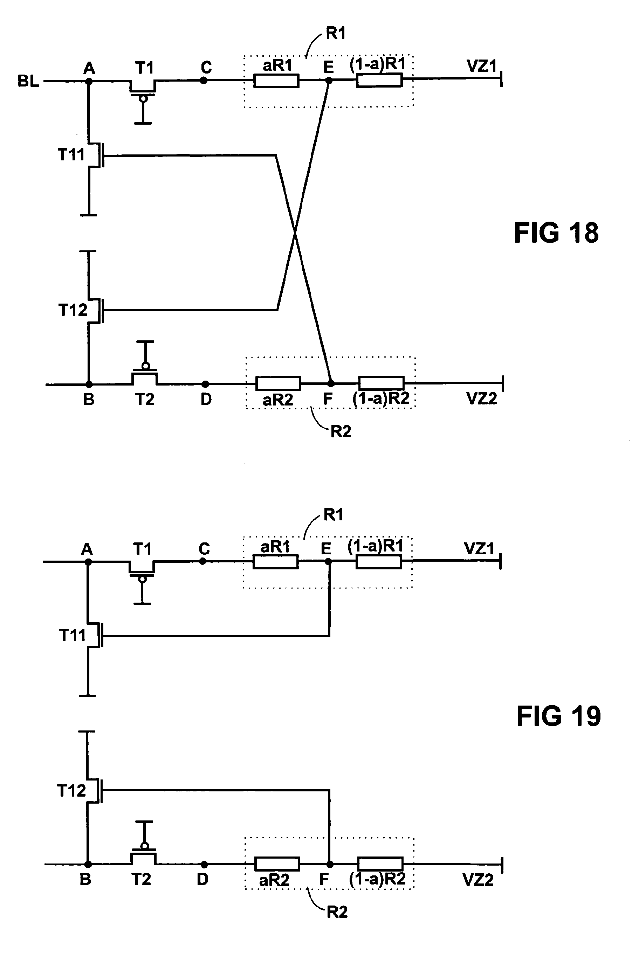

Von den genannten Möglichkeiten wird zunächst unter Bezugnahme auf die Figuren 2 bis 17 die erstgenannte Möglichkeit näher erläutert. Im Anschluß daran wird unter Bezugnahme auf die Figuren 18 bis 24 die zweite Möglichkeit näher erläutert.

Der prinzipielle Aufbau einer Verstärkerstufe, in welcher von der erstgenannten Möglichkeit Gebrauch gemacht wird, ist in Figur 2 dargestellt.

Die Anordnung gemäß Figur 2 ist symmetrisch aufgebaut und besteht aus kreuzgekoppelten (Verstärker-)Zweigen VZ1 und VZ2. Jeder der Zweige enthält einen PMOS-Transistor T1 bzw. T2 und einen dazu in Reihe geschalteten Widerstand R1 bzw. R2. Die zu untersuchenden Bitleitungen BL und BLB sind mit den Sourceanschlüssen der (im betrachteten Beispiel drainseitig über die Widerstände R1 und R2 auf Masse liegenden) Transistoren T1 und T2 verbunden. Die Gateanschlüsse der Transistoren T1 und T2 werden mit einer am Widerstand des jeweils anderen Zweiges abgegriffenen Spannung beaufschlagt. Die an den Widerständen abgegriffenen Spannungen (und damit auch das Ausmaß der Kopplung der Zweige VZ1 und VZ2) sind durch eine Variierung des Abgriffs an den Widerständen R1 und R2 und/oder durch eine Veränderung der Widerstände oder des Widerstandsverhältnisses der die Widerstände R1 und R2 bildenden, diesseits und jenseits des Abgriffpunktes liegenden Teilwiderstände aR und (1-a)R veränderbar. Dadurch läßt sich der Eingangswiderstand der Anordnung gemäß Figur 2 innerhalb gewisser Grenzen beliebig einstellen; er kann dabei sowohl positive als auch negative Werte annehmen.

Die Widerstände R1 und R2 lassen sich beispielsweise
- durch anzapfbare lineare Widerstände (beispielsweise Widerstände in Dünnfilm- oder Poly-Si-Ausführung),
- durch die Reihenschaltung einer PMOS-Diode und einer PMOS-Gatestufe, deren Eingangswiderstand über eine Referenzspannung und/oder über die Transistordimensionierung einstellbar ist,
- durch die Reihenschaltung einer NMOS-Diode und einer NMOS-Sourcestufe, deren Widerstand über eine Referenzspannung und/oder über die Transistordimensionierung einstellbar ist, oder
- durch einen CMOS-Spannungsteiler
realisieren.

Die Realisierung der Widerstände R1 und R2 durch die erstgenannte Möglichkeit bedarf keiner näheren Erläuterung.

Die Realisierung der Widerstände R1 und R2 durch die zweitgenannte Möglichkeit eignet sich insbesondere in Fällen, in welchen die Widerstände R1 und R2 hochohmig sind oder sein sollen. Diese Realisierungs-Möglichkeit ist in Figur 3 dargestellt. Dabei werden die PMOS-Diode durch einen entsprechend verschalteten PMOS-Transistor T51, und die PMOS-Gatestufe durch einen entsprechend verschalteten PMOS-Transistor T52 gebildet; die Referenzspannung ist mit U_{Ref} bezeichnet und wird auf den Gateanschluß des Transistors T52 gegeben.

Die Realisierung der Widerstände R1 und R2 durch die drittgenannte Möglichkeit eignet sich insbesondere in Fällen, in welchen die Widerstände R1 und R2 niederohmig sind oder sein sollen. Diese Realisierungs-Möglichkeit ist in Figur 4 dargestellt. Dabei werden die NMOS-Diode durch einen entsprechend verschalteten NMOS-Transistor T53, und die NMOS-Sourcestufe durch einen entsprechend verschalteten NMOS-Transistor T54 gebildet; die Referenzspannung ist wiederum mit U_{Ref} bezeichnet und wird auf den Gateanschluß des Transistors T54 gegeben.

Die Realisierung der Widerstände R1 und R2 durch die letztgenannte Möglichkeit ist in Figur 5 dargestellt. Sie besteht im betrachteten Beispiel aus einer Reihenschaltung eines PMOS-Transistors T55 und eines NMOS-Transistors T56, deren Gateanschlüsse mit einer Referenzspannung U_{Ref} beaufschlagt sind.

Bei den in den Figuren 3 bis 5 gezeigten Realisierungsmöglichkeiten für die Widerstände R1 und R2 in Figur 2 erfolgt der Abgriff der auf die Gateanschlüsse der Transistoren T1 und T2 gegebenen Spannung zwischen den Transistoren T51 und T52 (Figur 3), bzw. zwischen den Transistoren T53 und T54 (Figur 4) bzw. zwischen den Transistoren T55 und T56 (Figur 5). Diese Spannung ist, wie vorstehend bereits erwähnt wurde, durch eine entsprechende Dimensionierung der Transistoren und/oder durch eine Variierung der Referenzspannung U_{Ref,} also statisch und/oder dynamisch variierbar.

Die dynamische Variierung der auf die Gateanschlüsse der Transistoren T1 und T2 gegebenen Spannung (die Variierung dieser Spannung durch eine Variierung der Referenzspannung) erweist sich als vorteilhaft, weil der Leseverstärker dadurch jederzeit optimal an die im Speicherbaustein herrschenden Verhältnisse angepaßt werden kann. Damit kann sichergestellt werden, daß der Eingangswiderstand des Leseverstärkers unter allen Umständen einen gewünschten Wert aufweist und/oder einen bestimmten Wert nicht unterschreitet oder überschreitet.

Die statische Variierung der auf die Gateanschlüsse der Transistoren T1 und T2 gegebenen Spannung (die Variierung dieser Spannung durch eine entsprechende Dimensionierung der Transistoren) erweist sich als vorteilhaft, weil dadurch ohne Veränderung des prinzipiellen Aufbaus der Schaltung, also auf sehr einfache Weise, Leseverstärker mit beliebigen Eingangswiderständen hergestellt werden können.

Insbesondere wenn die Variierung des Eingangswiderstandes des Leseverstärkers durch eine Variierung der Referenzspannung U_{Ref} erfolgt, kann mit der Variierung des Eingangswiderstandes des Leseverstärkers auch eine Veränderung der Widerstände R1 und R2 einhergehen.

Dies läßt sich vermeiden, wenn in der Anordnung gemäß Figur 2 in die Rückkopplungszweige, über welche den Gateanschlüssen der Transistoren T1 und T2 die an den Widerständen R1 bzw. R2 abgegriffenen Spannungen zugeführt werden, Trennspannungsverstärker V eingefügt werden. Bei den Trennspannungsverstärkern V kann es sich um nichtinvertierende Verstärker (Verstärkungsfaktor A > 0) oder um invertierende Verstärker (Verstärkungsfaktor A < 0) handeln.

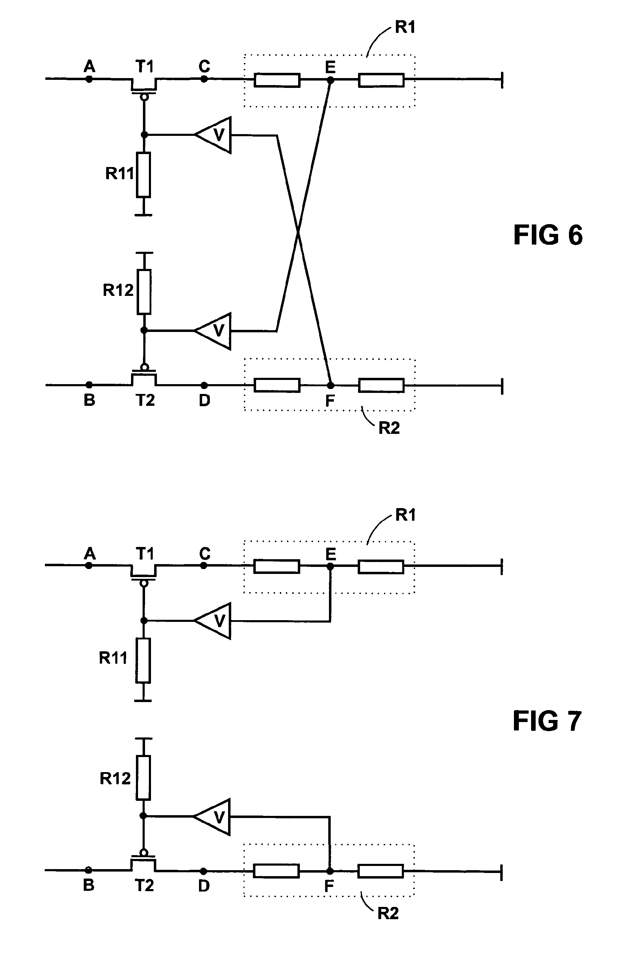

Der Aufbau einer mit nichtinvertierenden Verstärkern V versehenen Anordnung gemäß Figur 2 ist in Figur 6 gezeigt, und der Aufbau einer mit invertierenden Verstärkern V versehenen Anordnung gemäß Figur 2 ist in Figur 7 gezeigt.

Im letztgenannten Fall wird aus der Kreuzkopplung der Zweige VZ1 und VZ2 eine "normale" Rückkopplung.

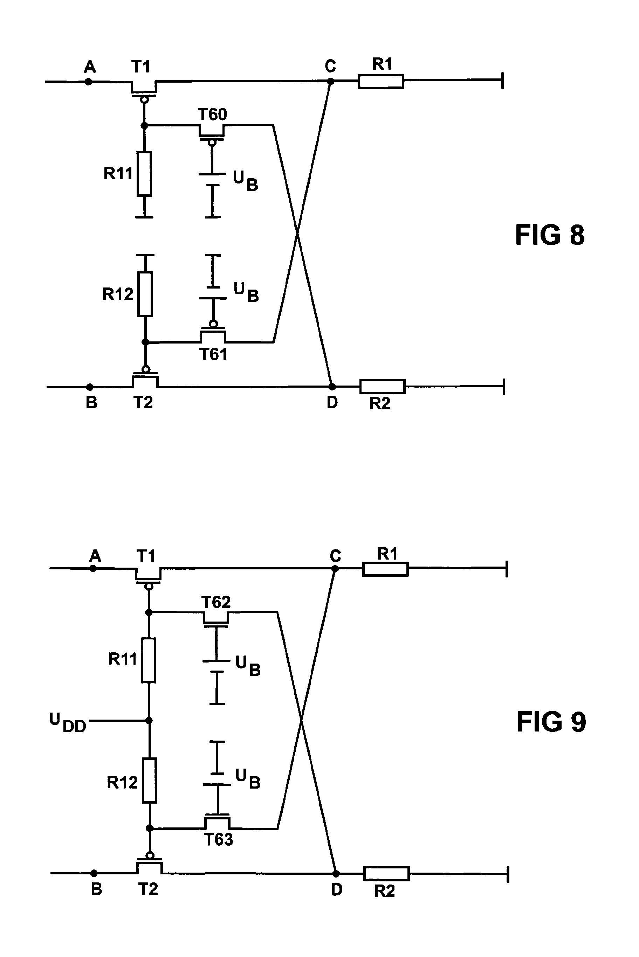

Der Einsatz der Verstärker V ermöglicht es, die über diese auf die Gateanschlüsse der Transistoren T1 und T2 zu gebende Spannung vor den Widerständen R1 und R2 abzugreifen (siehe Figur 8 ff.).

Die nichtinvertierenden Verstärker V in den Kreuz- bzw. Rückkopplungszweigen können jeweils durch eine Gatestufe realisiert werden. Die jeweiligen Gatestufen können dabei auf verschiedenerlei Art und Weise aufgebaut werden.

Wie aus der Figur 8 ersichtlich ist, können die die Verstärker bildenden Gatestufen beispielsweise unter Verwendung von PMOS-Transistoren T60 bzw. T61 realisiert werden (Sourceanschluß mit den Zweigen VZ1 bzw. VZ2 verbunden, Gateanschluß mit einer zur Arbeitspunkteinstellung dienenden Spannung U_{B} beaufschlagt, Drainanschluß mit dem Gateanschluß des Transistors T1 bzw. T2 verbunden sowie über Widerstände R11 und R12 mit Masse verbunden).

Wie aus der Figur 9 ersichtlich ist, können die die Verstärker bildenden Gatestufen auch unter Verwendung von NMOS-Transistoren T62 und T63 realisiert werden (Sourceanschluß mit den Zweigen VZ1 bzw. VZ2 verbunden, Gateanschluß mit einer zur Arbeitspunkteinstellung dienenden Spannung U_{B} beaufschlagt, Drainanschluß mit dem Gateanschluß des Transistors T1 bzw. T2 verbunden sowie über Widerstände R11 und R12 mit der Versorgungsspannung U_{DD} verbunden).

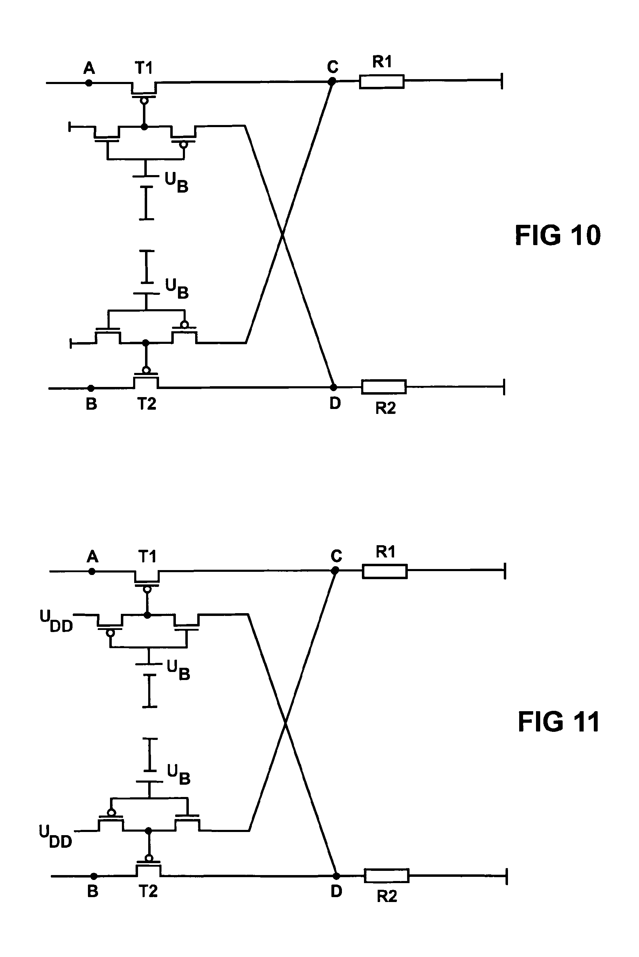

Die die Verstärker bildenden Gatestufen können auch in CMOS-Technik aufgebaut werden. Dies ist in den Figuren 10 und 11 veranschaulicht, wobei die in der Figur 10 gezeigte Anordnung der in der Figur 8 gezeigten Anordnung entspricht, und wobei die in der Figur 11 gezeigte Anordnung der in der Figur 9 gezeigten Anordnung entspricht.

Beim Einsatz von Verstärkern in den Kreuzkopplungszweigen gemäß Figur 6 hat eine Veränderung der Verstärkung der Verstärker V über den Eingangswiderstand des Leseverstärkers auch Einfluß auf die Widerstände R1 und R2. Dieser Einfluß auf die Widerstände R1 und R2 ist aber erheblich schwächer als bei Leseverstärkern nach Art der Figur 2.

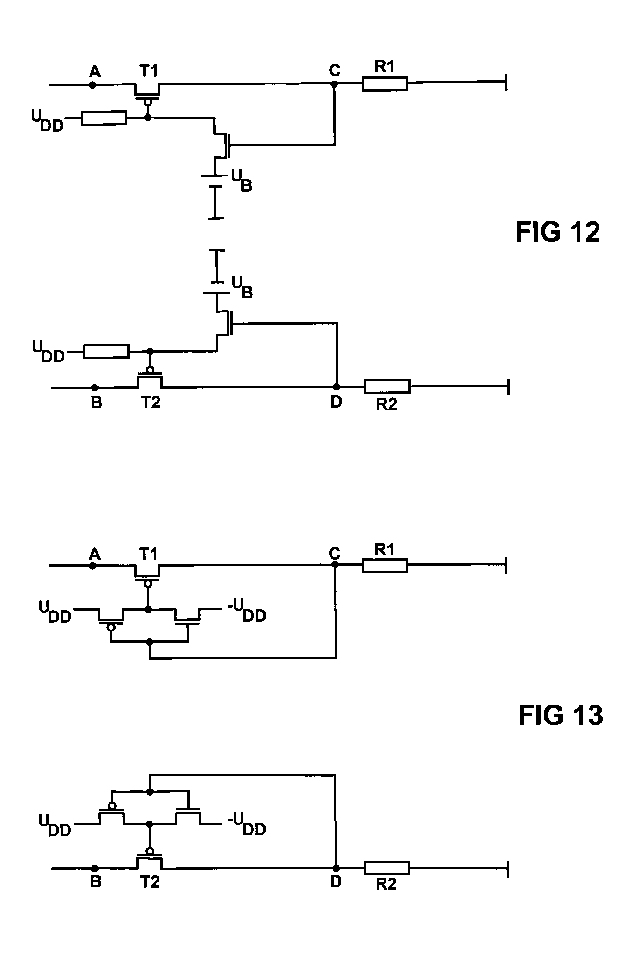

Dieser Einfluß entfällt völlig, wenn die Anordnung nach Figur 7 verwendet wird, weil die darin enthaltenen Verstärker V - insbesondere wenn sie durch eine Sourcestufe (siehe Figur 12) oder durch einen CMOS-Inverter (siehe Figur 13) gebildet werden - rückwirkungsfrei an den Widerständen R1 bzw. R2 bzw. an Abgriffen derselben liegen.

Dies erlaubt die Verwendung hochohmiger Widerstände R1 bzw. R2, wodurch die Transistoren T1 und T2 besonders hohe Spannungsverstärkungen aufweisen können.

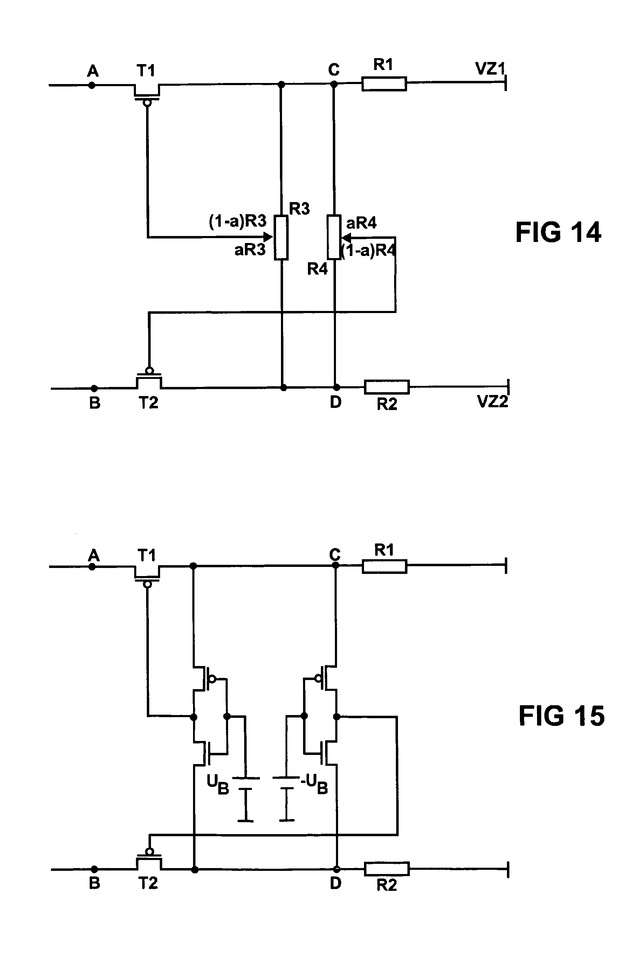

Eine weitere Möglichkeit für einstellbare Spannungsrück- und/oder Kreuzkopplungen ist in Figur 14 veranschaulicht. Bei dieser Anordnung wird die an die Gateanschlüsse der Transistoren T1 und T2 angelegte Spannung an zwischen den Zweigen VZ1 und VZ2 (hier: zwischen den Drainanschlüssen der Transistoren T1 und T2) vorgesehenen Widerständen R3 und R4 (R3=R4), genauer gesagt an gegenläufigen Abgriffen derselben abgegriffen.

Der gegenläufige Doppelspannungsteiler gemäß Figur 14 läßt sich beispielsweise durch Reihenschaltung von drei (z.B. durch MOS-Transistoren gebildeten) Widerständen mit zwei dazwischen liegenden Abgriffspunkten bilden.

Eine andere Möglichkeit zur Realisierung des gegenläufigen Doppelspannungsteilers gemäß Figur 14 besteht im Vorsehen eines doppelten CMOS-Spannungsteilers mit verstellbarer gegenpoliger Gatehilfsvorspannung. Eine solche Anordnung ist in Figur 15 dargestellt.

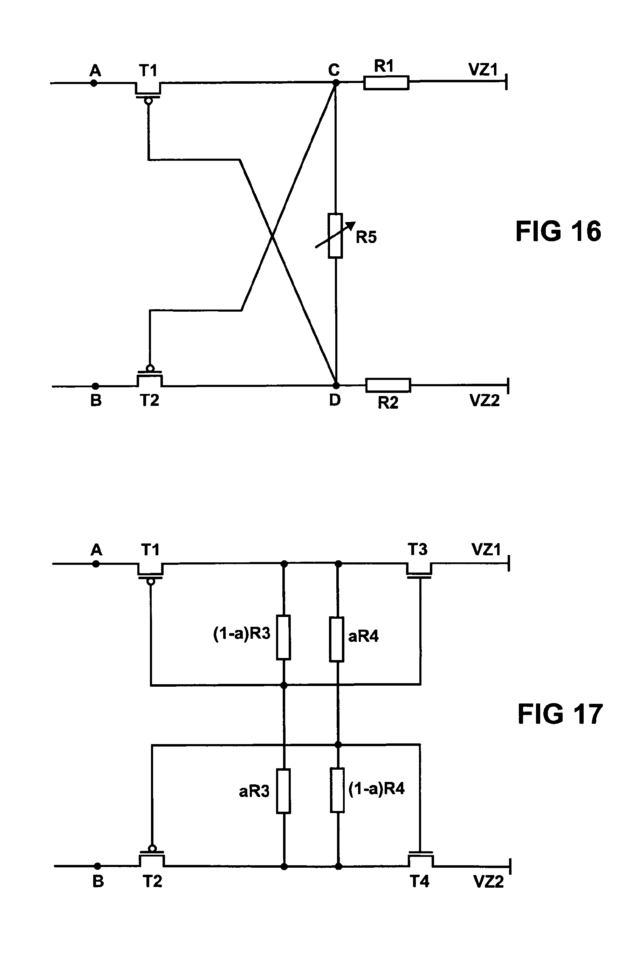

Für den Fall, daß der Parameter a in der Anordnung nach Figur 14 den Wert 1 annimmt, läßt sich die Anordnung gemäß Figur 14 durch die Anordnung gemäß Figur 16 realisieren. Der in dieser Anordnung anstelle der Widerstände R3 und R4 vorgesehene Widerstand R5 kann beispielsweise als spannungsgesteuerter MOS-Widerstand realisiert werden.

Eine besonders einfache Anordnung ergibt sich, wenn die in den Zweigen VZ1 und VZ2 vorgesehenen Widerstände R1 und R2 durch NMOS-Transistoren T3 bzw. T4 realisiert werden, deren Gateanschlüsse mit den Gateanschlüssen der Transistoren T1 und T2 verbunden sind. Dies ist beispielhaft in der Figur 17 dargestellt; die darin gezeigte Anordnung resultiert aus einer wie erwähnt erfolgten Modifikation der in der Figur 14 gezeigten Anordnung.

Die vorstehenden, unter Bezugnahme auf die Figuren 2 bis 17 erfolgten Erläuterungen bezogen sich auf einen Leseverstärker, bei welchem die Einstellbarkeit des Eingangswiderstandes desselben dadurch erreicht wird, daß eingangsseitig ein symmetrischer Gatestufenverstärker mit einstellbarer Spannungs-Rückkopplung oder Spannungs-Kreuzkopplung vorgesehen wird.

wie eingangs bereits erwähnt wurde, läßt sich eine Einstellbarkeit des Eingangswiderstandes des Leseverstärkers auch dadurch realisieren, daß der Leseverstärker eingangsseitig mit einem symmetrischen Gatestufenverstärker versehen ist, dem eingangsseitig zwei Stromquellen zugeschaltet sind, die unter Verwendung von aus den Verstärker-Zweigen VZ1 und VZ2 abgegriffenen Spannungen variabel steuerbar sind.

Diese zweite Möglichkeit wird nachfolgend unter Bezugnahme auf die Figuren 18 bis 24 näher erläutert.

Der symmetrische Gatestufenverstärker besteht wiederum aus zwei Verstärker-Zweigen VZ1 und VZ2, von welchen jeder einen PMOS-Transistor T1 bzw. T2 und einen dazu in Reihe geschalteten Widerstand R1 bzw. R2 enthält. Insoweit besteht kein Unterschied zu den Leseverstärkern der zuvor beschriebenen Art. Die Zweige VZ1 und VZ2 sind aber eingangsseitig mit steuerbaren Stromquellen verbunden. Diese Stromquellen werden im betrachteten Beispiel durch MOS-Transistoren realisiert, die entweder in Sourceschaltung oder in Drainschaltung arbeiten. Durch eine entsprechende Steuerung der Stromquellen kann der Eingangswiderstand der Anordnung innerhalb bestimmter Grenzen frei eingestellt werden.

Eine solche Anordnung ist in Figur 18 dargestellt. Die zu untersuchenden Bitleitungen BL und BLB sind mit den Sourceanschlüssen der (im betrachteten Beispiel gateseitig direkt und drainseitig über die Widerstände R1 und R2 auf Masse liegenden) Transistoren T1 und T2 verbunden. Die Stromquellen, mit denen die Zweige VZ1 und VZ2 eingangsseitig verbunden sind, werden durch in Sourceschaltung arbeitende NMOS-Transistoren T11 und T12 gebildet. Die Sourceanschlüsse dieser Transistoren liegen auf Masse, die Drainschlüsse sind mit den Sourceanschlüssen der Transistoren T1 und T2 verbunden, und die Gateanschlüsse werden mit einer am Widerstand des jeweils anderen Zweiges abgegriffenen Spannung beaufschlagt. Die an den Widerständen abgegriffenen Spannungen und damit auch die durch die Transistoren T11 und T12 fließenden Ströme sind durch eine Variierung des Abgriffs an den Widerständen R1 und R2 und/oder durch eine Veränderung der Widerstände oder des Widerstandsverhältnisses der die Widerstände R1 und R2 bildenden, diesseits und jenseits des Abgriffpunktes liegenden Teilwiderstände aR und (1-a)R veränderbar. Dadurch läßt sich der Eingangswiderstand der Anordnung gemäß Figur 18 innerhalb gewisser Grenzen beliebig einstellen.

Die Gateanschlüsse der Transistoren T11 und T12 können auch mit Spannungen beaufschlagt werden, die am Widerstand des Zweiges abgegriffen werden, mit welchen die Transistoren T11 und T12 verbunden sind. Dies ist in Figur 19 veranschaulicht.

Die Widerstände R1 und R2, an denen sich verschiedene Spannungen abgreifen lassen, können beispielsweise durch Anordnungen gemäß den Figuren 3 bis 5 gebildet werden. Die Spannungen, mit denen die Gateanschlüsse der Transistoren beaufschlagt werden, können auch von zwischen den Zweigen VZ1 und VZ2 angeordneten (Quer-)Spannungsteilern wie beispielsweise bei der Anordnung in Figur 14 abgegriffen werden

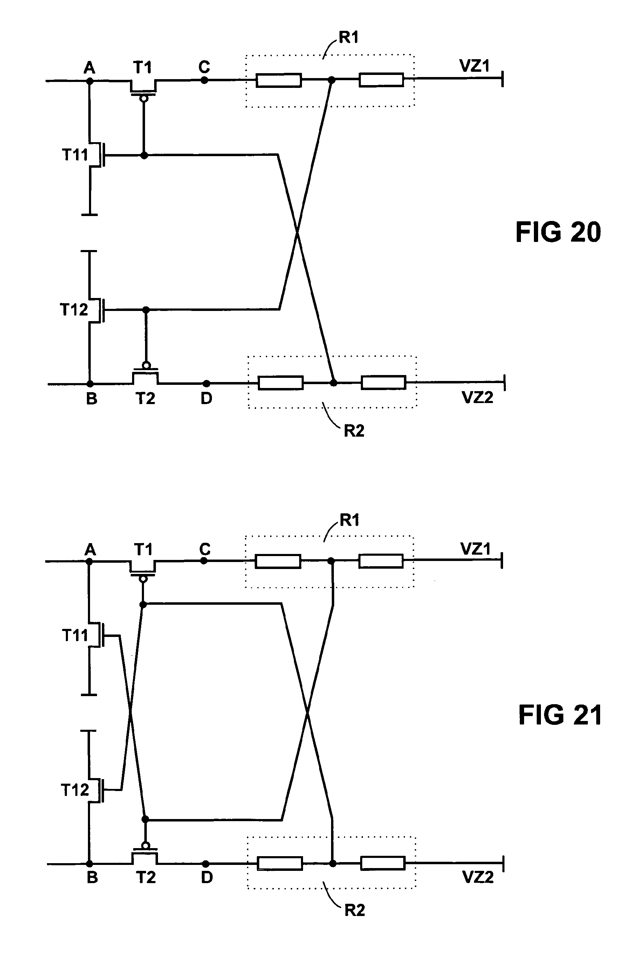

Es ist auch möglich, die Gateanschlüsse der Transistoren T1 und T2 und die Gateanschlüsse der Transistoren T11 und T12 wie in den Figuren 20 und 21 gezeigt zu verbinden. Dabei erweist sich insbesondere die Anordnung gemäß Figur 21 als vorteilhaft, denn durch diese läßt sich der Eingangswiderstand zwischen sehr kleinen positiven Werten und negativen Werten variieren.

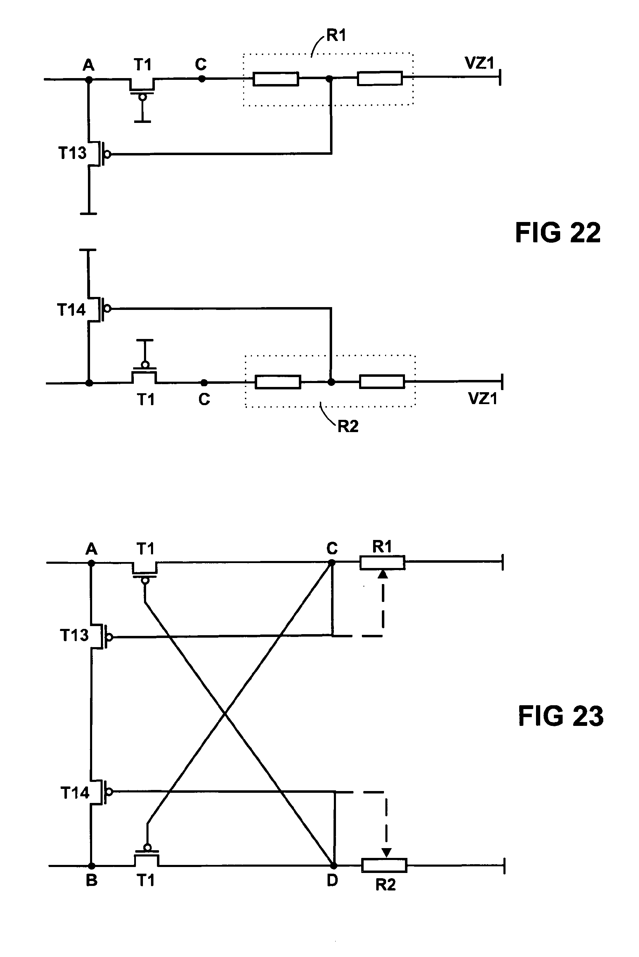

Die durch die Transistoren T11 und T12 gebildeten Stromquellen können, wie vorstehend bereits erwähnt wurde, auch durch in Drainschaltung arbeitende Transistoren realisiert werden. Eine Anordnung, bei welcher dies praktziert wurde, ist in Figur 22 gezeigt. Die die Stromquellen bildenden Transistoren sind die Transistoren T13 und T14. Es handelt sich um PMOS-Transistoren, deren Sourceanschlüsse mit den Zweigen VZ1 und VZ2 verbunden sind, deren Drainanschlüsse auf Masse liegen, und deren Gateanschlüsse mit an den Widerständen R1 und R2 abgegriffenen Spannungen beaufschlagt werden.

Die Spannungen, mit denen die Gateanschlüsse der Transistoren T13 und T14 beaufschlagt werden, werden jeweils an den Widerständen abgegriffen, die in dem Zweig liegen, mit welchem der betreffende Transistor verbunden ist.

Die Anordnung gemäß Figur 22 kann dahingehend modifiziert werden, daß die Gateanschlüsse der Transistoren T1 und T2 nicht auf Masse liegen, sondern mit Spannungen beaufschlagt werden, die vom jeweils anderen Zweig abgegriffen werden. Eine solche Anordnung ist in Figur 23 gezeigt.

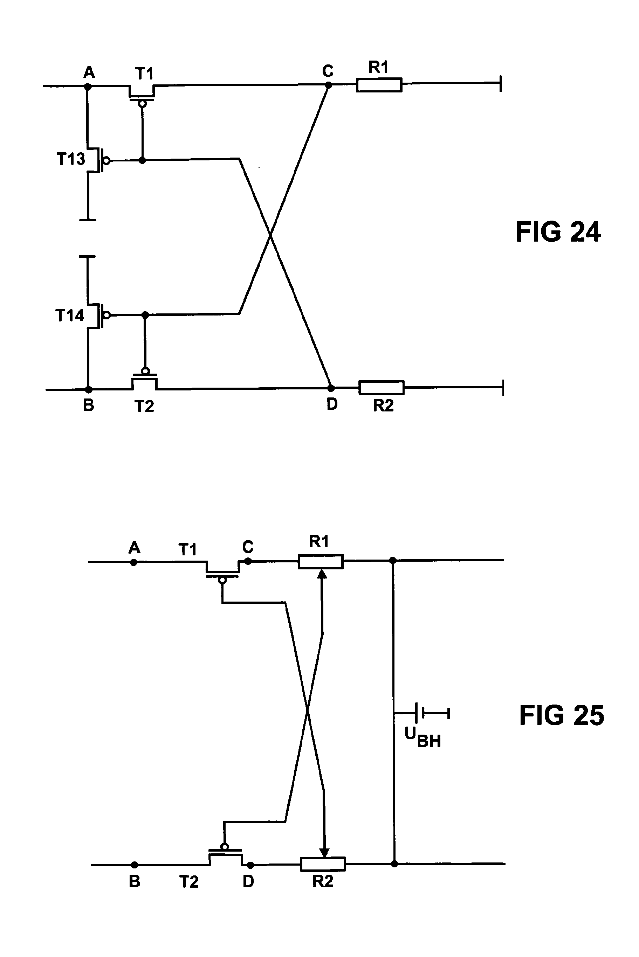

Die Anordnung gemäß Figur 23 kann dahingehend modifiziert werden, daß die Gateanschlüsse der Transistoren T13 und T14 mit den Spannungen beaufschlagt werden, mit denen die Gateanschlüsse der Transistoren T1 und T2 beaufschlagt werden, die sich in dem Zweig befinden, mit dem der betreffende Transistor verbunden ist. Eine solche Anordnung ist in Figur 24 gezeigt.

Die vorstehend unter Bezugnahme auf die Figuren 2 bis 24 beschriebenen Anordnungen lassen sich zumindest teilweise weiter modifizieren.

So ist es beispielsweise möglich, die Zweige VZ1 und VZ2 ausgangsseitig mit einer Hilfsspannung U_{BH} zu beaufschlagen (anstatt sie wie in den Figuren 2 bis 24 dargestellt auf Masse zu legen). Ein Ausführungsbeispiel einer solchen Anordnung ist in Figur 25 dargestellt. Die Spannung U_{BH} kann eine statisch oder dynamisch einstellbare Spannung sein. Durch die Spannung U_{BH} lassen sich die Arbeitspunkte der Zweige VZ1 und VZ2 wunschgemäß verändern.

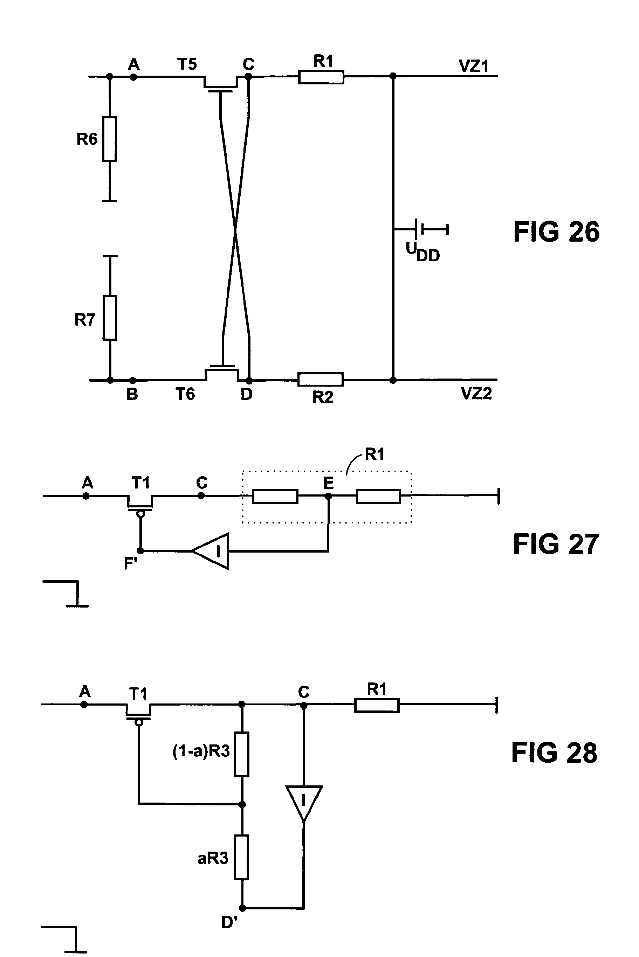

Ferner besteht auch keine Einschränkung darauf, daß die Zweige VZ1 und VZ2 aus einer Reihenschaltung einer p-Kanal-Eingangsgatestufe und eines Widerstandes bestehen. Es kann auch die gefaltete komplementäre Gateeingangsstufe eingesetzt werden. Dabei arbeiten die Bitleitungen auf Lastelemente bzw. Widerstände R6 und R7 der Bitleitung, welche auch Stromsenken sein können; die die komplementär ausgeführte Gatestufe bildenden NMOS-Transistoren T5 und T6 liegen dann eingangsseitig an den genannten Widerständen, und die Widerstände R1 und R2 an der Versorgungsspannung U_{DD}. Eine Anordnung dieser Art ist in Figur 26 dargestellt; das gezeigte Beispiel ist eine Modifikation der in der Figur 2 gezeigten Anordnung. Die Widerstände R6 und R7 können bei Bedarf wie die Bitleitungs- und Auswahltransistor-Widerstände über einen negativen Eingangswiderstand des Leseverstärkers kompensiert werden. Bei Anordnungen nach Art der Figur 26 lassen sich im übrigen auch die in den Figuren 2 bis 24 dargestellten und unter Bezugnahme darauf beschriebenen Methoden zur Eingangswiderstand-Variierung anwenden. Gegebenenfalls sind zusätzliche und/oder andere Hilfsspannungen bzw. Referenzspannungen für geeignete Arbeitspunkteinstellungen vorzusehen.

Das Prinzip der Variierung des Eingangswiderstandes von positiven Werten bis hin zu negativen Werten durch variable Rückkopplung läßt sich auch bei unsymmetrisch aufgebauten Anordnungen einsetzen. Die bei symmetrischen Anordnungen durch die Schaltungssymmetrie gewonnene Phasenlage der Rückkopplungsspannung muß dann unter Umständen an gespiegelten Netzwerkknoten nachgebildet werden, was beispielsweise unter Verwendung von invertierenden Spannungsfolgern (Invertern) geschehen kann. Die symmetrische Anordnung gemäß Figur 2 läßt sich so unter Verwendung eines Inverters I in die unsymmetrische Anordnung gemäß Figur 27 überführen; die sich am Knoten F' in Figur 27 einstellende Spannung entspricht der sich am Knoten F in Figur 2 einstellenden Spannung.

Auch die symmetrische Anordnung gemäß Figur 14 läßt sich unter Verwendung eines Inverters I in eine unsymmetrische Anordnung überführen. Die entsprechende unsymmetrische Anordnung ist in Figur 28 dargestellt; die sich am Knoten D' in Figur 28 einstellende Spannung entspricht der sich am Knoten D in Figur 14 einstellenden Spannung.

Nach diesem Prinzip lassen sich auch die anderen zuvor beschriebenen Anordnungen in unsymmetrische Anordnungen überführen.

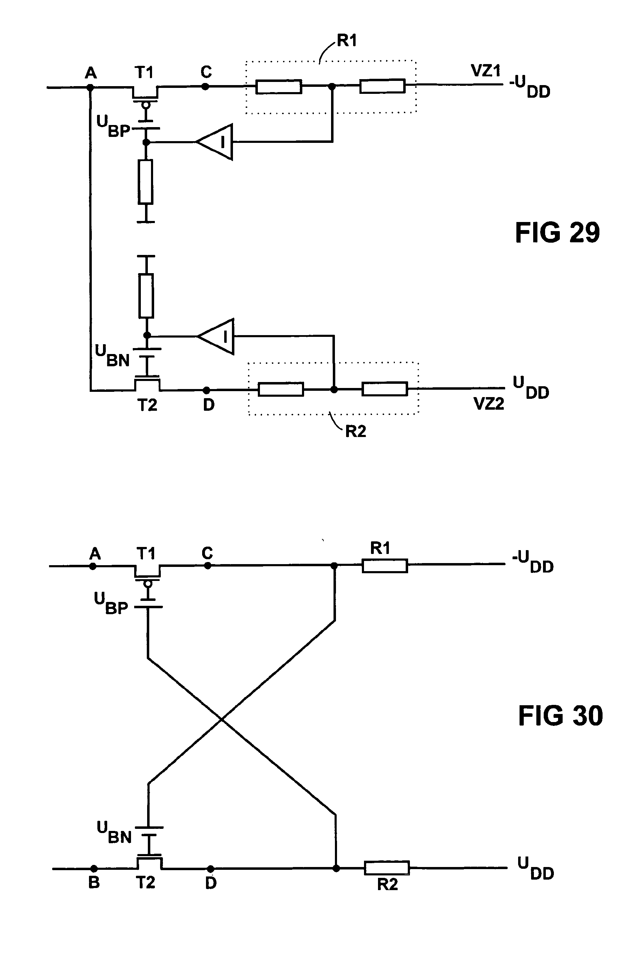

Die Unsymmetrie der Anordnung kann auch darin bestehen, daß die Zweige VZ1 und VZ2 unterschiedlich ausgebildet sind (beispielsweise zueinander komplementäre Transistoren aufweisen). Auch an solchen Anordnungen kann der Eingangswiderstand variiert werden. Zwei Ausführungsbeispiele für mögliche praktische Realisierungen von Anordnungen dieser Art sind in den Figuren 29 und 30 dargestellt.

Der Einsatz von wie beschrieben oder anders aufgebauten unsymmetrischen Leseverstärkern erweist sich insbesondere für die Verarbeitung von bipolaren Signalen als vorteilhaft.

Den vorstehend unter Bezugnahme auf die Figuren 2 bis 30 beschriebenen Anordnungen ist gemeinsam, daß deren Eingangswiderstand auf sehr einfache Weise statisch (durch entsprechende Dimensionierung bestimmter Bauteile) und/oder dynamisch (durch entsprechende Einstellung oder einen entsprechenden Betrieb bestimmter Bauteile) variierbar bzw. einstellbar ist.

Die Anordnungen unterscheiden sich jedoch insbesondere hinsichtlich der praktischen Realisierbarkeit, der Lage und der Größe des Bereichs, innerhalb dessen der Eingangswiderstand variiert werden kann, der Größe und der Anzahl der Stufen, in denen der Eingangswiderstand verändert werden kann, des Verlaufs der Eingangswiderstand/Stellgrößen-Kennlinie, der Stromverstärkung, und der Rückwirkung auf andere Eigenschaften des Leseverstärkers.

Welche Anordnung für den jeweiligen Einsatz optimal ist, hängt von den jeweiligen Gegebenheiten ab. Die vorstehend beschriebenen und ähnlich aufgebaute Anordnungen eignen sich jedoch ausnahmslos hervorragend für den Einsatz in Leseverstärkern. Sie bilden dabei vorzugsweise die erste von zwei oder mehreren Verstärkerstufen. Durch die zweite und/oder weitere Verstärkerstufen erfolgt eine (weitere) Stromverstärkung und eine Strom/Spannungs-Wandlung. So aufgebaute Leseverstärker sind Stromverstärker mit Strom/Spannungs-Wandlern am Ausgang. Es ist jedoch auch möglich, die von den vorstehend beschriebenen Anordnungen ausgegebenen Ströme sofort, d.h. ohne (weitere) Stromverstärkung einer Strom/Spannungs-Wandlung zu unterziehen, und die dabei erhaltene Spannung zu verstärken. In beiden Fällen liefern die Leseverstärker als Ausgangssignal eine Spannung, deren Höhe den Inhalt der ausgelesenen Speicherzelle repräsentiert.

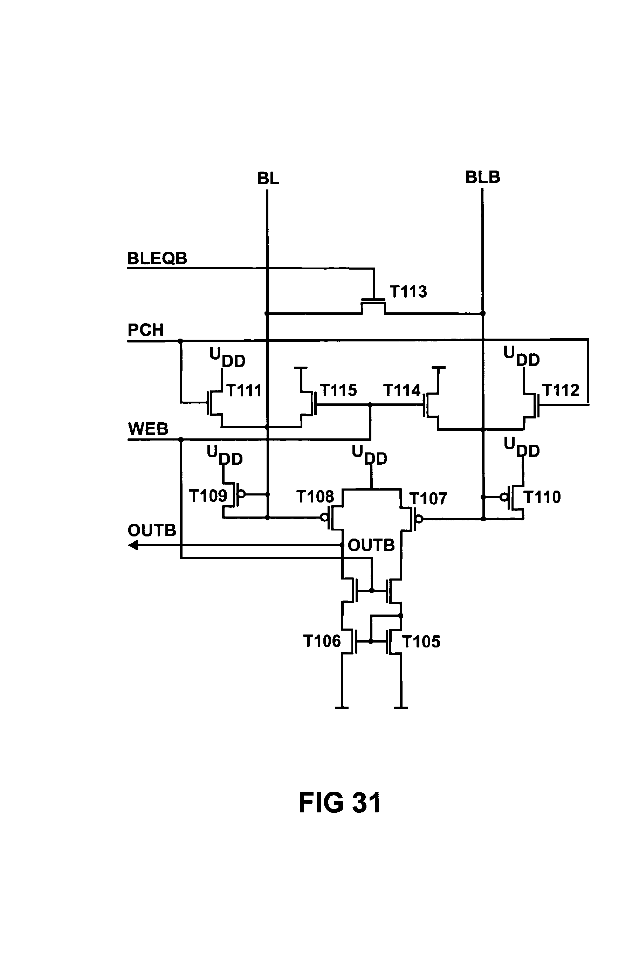

Ein anderer Leseverstärker, der die an herkömmlichen Leseverstärkern (insbesondere die an dem aus der US 5.253.137 bekannten Leseverstärker) kritisierten Nachteile ebenfalls nicht aufweist, ist in Figur 31 dargestellt und wird nachfolgend in Bezugnahme darauf beschrieben.

Der in Figur 31 gezeigte Leseverstärker zeichnet sich unter anderem dadurch aus, daß er am Eingang einen oder mehrere Transistoren enthält, über welche er die vom zu erfassenden Strom durchflossene Leitung(en) mit einem oder beiden Polen einer Spannungsquelle verbindet.

Die besagten Transistoren, die die Bitleitungen BL und BLB mit den Polen einer Spannungsquelle verbinden, sind im betrachteten Beispiel NMOS-Transistoren T111 und T115 (für die Bitleitung BL) und NMOS-Transistoren T112 und T114 (für die Bitleitung BLB). Diese Transistoren sind mit ihren jeweiligen Drainanschlüssen mit den Bitleitungen BL (Transistoren T111 und T115) bzw. BLB (Transistoren T112 und T114) verbunden, und sind mit ihren Sourceanschlüssen mit dem positiven Pol einer Spannungsquelle (Transistoren T111 und T112) bzw. mit dem negativen Pol der Spannungsquelle (Transistoren T114 und T115) verbunden. Die Spannungsquelle ist im betrachteten Beispiel die den Speicherbaustein mit Energie versorgende Versorgungsspannungsquelle; der positive Pol der Spannungsquelle liegt im betrachteten Beispiel auf dem Versorgungspotential U_{DD}, und der negative Pol der Spannungsquelle liegt im betrachteten Beispiel auf Massepotential. Die Gateanschlüsse der Transistoren T111 und T112 werden mit einem Signal PCH beaufschlagt, und die Gateanschlüsse der Transistoren T114 und T115 werden mit einem Signal WEB beaufschlagt, wobei die Signale PCH und WEB während des Auslesens einer Speicherzelle Werte annehmen, durch welche die Transistoren T111, T112, T114 und T115 in den leitenden Zustand versetzt werden. Dadurch stellt sich auf den Bitleitungen BL und BLB ein Potential U_{DD} - Uₜₕ (Uₜₕ ist die Thresholdspannung der Transistoren) ein, welches durch die auf den Bitleitungen BL und BLB fließenden Ströme nicht oder nur geringfügig beeinflußt wird.

Die die Bitleitungen BL und BLB mit einem der beiden Pole einer Spannungsquelle verbindenden Transistoren (im betrachteten Beispiel die Transistoren T111, T112, T114 und T115) bilden einen Impedanzwandler (eine erste Verstärkerstufe) des Leseverstärkers.

Ein derartiger Impedanzwandler erweist sich in zweifacher Hinsicht als vorteilhaft. Einerseits gelingt es dadurch, daß ein damit ausgestatteter Leseverstärker ohne Rückkopplung von Signalen einen sehr geringen positiven Eingangswiderstand aufweist (der Eingangswiderstand des Leseverstärkers wird durch den Kleinsignalausgangsleitwert der Transistoren T111, T112, T114 und T115 bestimmt), und andererseits können die von den Bitleitungen angesteuerten Transistoren der sich an den Impedanzwandler anschließenden Verstärkerstufe des Leseverstärkers als PMOS-Transistoren ausgebildet sein. Dies gilt übrigens auch für den Fall, daß die Transistoren T114 und T115 nicht vorhanden sind, die Bittleitungen BL und BLB also jeweils nur jeweils über einen Transistor mit einem Pol (dem positiven Pol) der Spannungsquelle verbunden sind; durch die Transistoren T114 und T115 kann der Eingangswiderstand des Leseverstärkers jedoch noch etwas weiter abgesenkt werden als es ohne sie der Fall ist.

Da der Impedanzwandler ohne Rückkopplung von Signalen auskommt, weist er unabhängig von der Art und der praktischen Realisierung des Speicherbausteins, in dem er zum Einsatz kommt, keine Probleme mit der Zuverlässigkeit auf; rückgekoppelte Systeme können insbesondere dann, wenn sie wie beispielsweise der Impedanzwandler des herkömmlichen Leseverstärkers gemäß der US 5.253.137 nicht an die jeweiligen Gegebenheiten (insbesondere an die Auswahltransistoren- und Bitleitungs-Widerstände) angepaßt sind, instabil werden.

Daß die mit den Bitleitungen in Verbindung stehenden Transistoren PMOS-Transistoren sind, ist vorteilhaft, da mit dieser Anordnung der in die zugeordnete Speicherzelle hineinfließende, genauer gesagt der von starken NMOS-Transistoren in der Speicherzelle getriebene Strom generiert werden kann.

Die besagten PMOS-Transistoren sind im betrachteten Beispiel Transistoren T108 und T109 (für die Bitleitung BL) und T107 und T110 (für die Bitleitung BLB).

Die Transistoren T108 und T109 bzw. T107 und T110 sind zusammen mit NMOS-Transistoren T105 und T106 wie in der Figur 31 gezeigt zu einer Anordnung verschaltet, welche die auf den Bitleitungen BL und BLB fließenden Ströme, auf zwei in Reihe geschaltete Transistoren (auf die Transistoren T106 und T108 spiegelt und das sich zwischen diesen Transistoren einstellende Potential als ein den Inhalt der auszulesenden Speicherzelle repräsentierendes Signal ausgibt. Im einzelnen stellen sich beim Auslesen einer Speicherzelle im Leseverstärker folgende Verhältnisse ein: Wenn der Inhalt der auszulesenden Speicherzelle "0" ist, fließt auf der Bitleitung BL Strom aus dem Leseverstärker zur auszulesenden Speicherzelle hin. Dieser Strom wird über den Transistor T109 in den Transistor T108 gespiegelt. D.h., durch den Transistor T108 fließt ein Strom, der richtungsmäßig dem über die Bitleitung BL fließenden Strom entspricht und proportional zu diesem ist. Auf der Bitleitung BLB stellt sich in dieser Phase ein Stromfluß in die umgekehrte Richtung, d.h. ein Stromfluß von der auszulesenden Speicherzelle zum Leseverstärker ein. Dieser Strom wird über die Transistoren T107 und T105 in den Transistor T106 gespiegelt. D.h., durch den Transistor T106 fließt ein Strom, der richtungsmäßig dem über die Bitleitung BLB fließenden Strom entspricht und proportional zu diesem ist. Zu dem zwischen den Transistoren T106 und T108 liegenden Knotenpunkt OUTB fließen damit verschiedene, nämlich die durch die Transistoren T106 und T108 fließenden Ströme. Im betrachteten Beispiel (Speicherzelleninhalt "0") ist der durch den Transistor T108 fließende Strom größer als der durch den Transistor T106 fließende Strom. Am Knoten OUTB stellt sich dadurch ein Potential ein, das nahe bei U_{DD} liegt. Im umgekehrten Fall, d.h. wenn der Inhalt der auszulesenden Speicherzelle "1" ist, drehen sich die beschriebenen Verhältnisse um. Als Folge dessen stellt sich am Knoten OUTB dann ein Potential nahe dem Massepotential ein. Das Potential am Knotenpunkt OUTB stellt mithin eine Information über den Inhalt der auszulesenden Speicherzelle dar.

Im betrachteten Beispiel sind zwischen den Transistoren T106 und T108 sowie zwischen den Transistoren T105 und T107 noch je ein NMOS-Transistor vorgesehen. Diese NMOS-Transistoren sind für das Auslesen der Speicherzellen nicht von Bedeutung. Sie werden durch das bereits erwähnte Signal WEB so angesteuert, daß sie während des Auslesens von Speicherzellen durchschalten und ansonsten sperren. Durch diese Transistoren wird verhindert, daß zu Zeiten außerhalb des Auslesens von Speicherzellen Querströme in der betreffenden Verstärkerstufe des Leseverstärkers fließen.

Die Transistoren T109 bis T112 haben neben den bereits beschriebenen Funktionen die zusätzlich Funktion, das Bitleitungspotential nach einem Beschreiben von Speicherzellen zu restaurieren. Dieser Vorgang kann durch ein vorübergehendes Durchschalten eines zwischen den Bitleitungen BL und BLB vorgesehenen NMOS-Transistors T113 beschleunigt werden.

Unter Verwendung von Leseverstärkern der zuletzt, unter Bezugnahme auf Figur 31 beschriebenen Art lassen sich auf besonders einfache Art und Weise Speichereinrichtungen schaffen, die unter allen Umständen klein realisierbar sind, einen geringen Energiebedarf haben, und schnell arbeiten.

Wie beschrieben oder anders ausgebildete Leseverstärker lassen sich auch in der Decodiereinrichtung einsetzen, durch welche aus einer an den Speicherbaustein angelegten (Speicherzellen-)Adresse die dadurch definierte Speicherzelle zum Auslesen oder Beschreiben ermittelt und ausgewählt wird. Der Einsatz von Leseverstärkern in Decodiereinrichtungen erweist sich insbesondere dann von Vorteil, wenn die betreffende Decodiereinrichtung mehrere kooperierende Decodier-Einheiten aufweist, die mehr oder weniger weit entfernt voneinander vorgesehen sind.

Mehrere Decodier-Einheiten werden beispielsweise zum Ermitteln und Auswählen der Speicherzellenzeile verwendet, in welcher sich die auszulesende oder zu beschreibende Speicherzelle befindet; die Auswahl der Speicherzellenzeile erfolgt dabei durch Anlegen eines entsprechenden Potentials an die der betreffenden Speicherzellenzeile zugeordnete Wortleitung.

Bei einer mehrere kooperierende Decodier-Einheiten aufweisenden Decodiereinrichtung läßt sich ein Leseverstärker dazu verwenden, die zwischen den Decodier-Einheiten versandten Signale entgegenzunehmen, zu erkennen, und (verstärkt) weiterzuleiten.

Die zwischen den Decodier-Einheiten versandten Signale können dann anders als bisher relativ leistungsschwach sein, wodurch die die Signale versendenden Treiber ebenfalls relativ schwach sein können und dadurch eine geringere Fläche beanspruchen, weniger Energie verbrauchen, und weniger elektromagnetische Störungen verursachen.

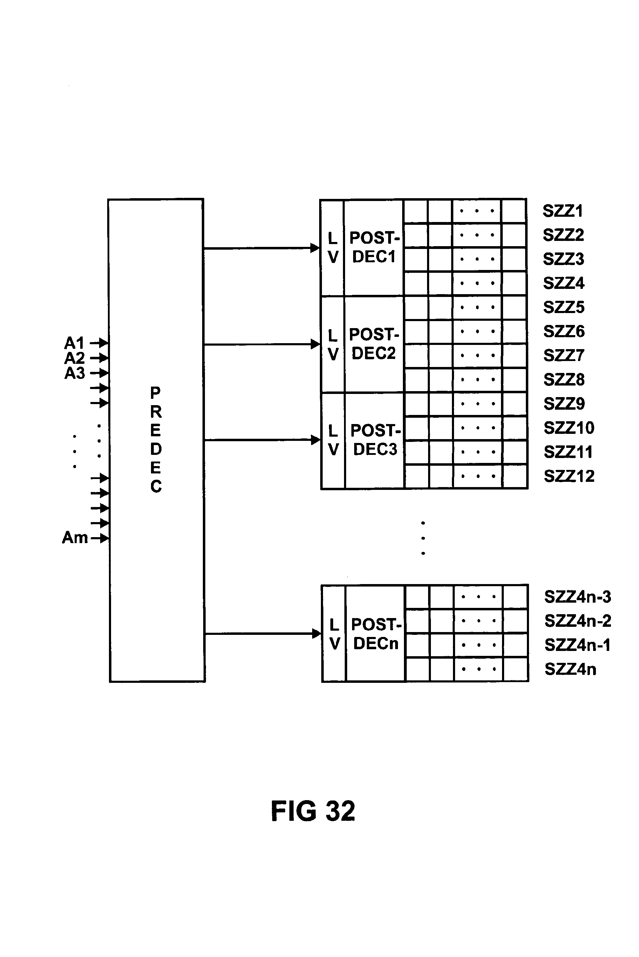

Eine Decodiereinrichtung, bei welcher sich der Einsatz eines oder mehrerer Leseverstärker als vorteilhaft erweist, ist eine Decodiereinrichtung, deren für die Speicherzellenzeilen-Ermittlung und -Auswahl zuständige Teil in einen sogenannten Predecoder und mehrere sogenannte Postdecoder untergliedert ist. Eine solche Decodiereinrichtung ist in Figur 32 dargestellt.

Der Predecoder ist dabei mit dem Bezugszeichen PREDEC bezeichnet, und die Postdecoder sind mit den Bezugszeichen POSTDEC1 bis POSTDECn bezeichnet.

Der Predecoder PREDEC führt, wie die Bezeichnung schon andeutet, eine Vordecodierung der ihm zugeführten Adressensignale A1 bis Am durch und liefert als Ergebnis einen (mehrere Speicherzellenzeilen umfassenden) Speicherzellenzeilen-Bereich, in welchem sich die auszulesende oder zu beschreibende Speicherzelle befindet.

Die Postdecoder führen die vom Predecoder begonnene Decodierung zu Ende. Genauer gesagt legen sie fest, in welcher Speicherzellenzeile des Speicherzellenzeilen-Bereichs sich die auszulesende oder die zu beschreibende Speicherzelle befindet. Welcher der Postdecoder angesprochen ist, wird durch den vom Predecoder bestimmten Speicherzellenzeilen-Bereich festgelegt; für jeden Speicherzellenzeilen-Bereich ist ein eigener Postdecoder vorgesehen (im betrachteten Beispiel der Postdecoder POSTDEC1 für einen die Speicherzellenzeilen SZZ1 bis SZZ4 umfassenden Speicherzellenzeilen-Bereich, der Postdecoder POSTDEC2 für einen die Speicherzellenzeilen SZZ5 bis SZZ8 umfassenden Speicherzellenzeilen-Bereich, usw.).

Die Untergliederung der Decodiereinrichtung in Predecoder und Postdecoder erweist sich als vorteilhaft, weil dadurch die von der Decodiereinrichtung belegte Chipfläche sinkt und die Leistungsfähigkeit der Decodiereinrichtung zunimmt.

In den Postdecodern POSTDEC1 bis POSTDECn ist jeweils ein Leseverstärker LV vorgesehen, durch welchen vom Predecoder erhaltene Signale und/oder Daten entgegengenommen und gegebenenfalls verstärkt weitergeleitet werden. Die vom Predecoder versandten Signale und/oder Daten können dadurch mit relativ geringer Leistung übertragen werden.

Wie beschrieben ausgebildete und eingesetzte Leseverstärker ermöglichen es, daß Speichereinrichtungen unter allen Umständen klein realisierbar sind, einen geringen Energiebedarf haben, und zuverlässig und schnell arbeiten.

### Bezugszeichenliste

- Ax: Adresssignale
- BL: Bitleitung
- BLB: Bitleitung
- I: Inverter
- LV: Leseverstärker
- LVU1: erste Verstärkerstufe
- LVU2: zweite Verstärkerstufe
- POSTDEC: Postdecoder
- PREDEC: Predecoder
- Rx: Widerstände
- SZ: Speicherzelle
- SZZx: Speicherzellen-Zeilen
- Tx: Transistoren
- TAx: Auswahltransistoren
- Ux: Spannungen
- V: Trennspannungsverstärker
- VZx: Verstärkerzweige
- WL: Wortleitung

## Patentansprüche

1. Speichereinrichtung mit einer Vielzahl von Speicherzellen (SZ) zum Speichern von Daten, und mit einer zwei oder mehrere miteinander kooperierende Decodier-Einheiten (PREDEC, POSTDEC) aufweisenden Decodiereinrichtung zur Auswahl der auszulesenden oder zu beschreibenden Speicherzelle(n),
**dadurch gekennzeichnet,**
**daß** die Decodier-Einheiten, die von anderen Decodier-Einheiten Daten oder Signale übermittelt bekommen, zumindest teilweise mit einem Leseverstärker (LV) zur Entgegennahme, Auswertung und/oder Weiterleitung dieser Daten oder Signale ausgestattet sind.

2. Speichereinrichtung nach Anspruch 1,
**dadurch gekennzeichnet,**
**daß** der Eingangswiderstand des Leseverstärkers variierbar ist.

3. Speichereinrichtung nach einem der vorhergehenden Ansprüche,
**dadurch gekennzeichnet,**
**daß** der Eingangswiderstand des Leseverstärkers derart variierbar ist, daß er dadurch an den Widerstand der dem Eingangsanschluß des Leseverstärkers vorgeschalteten Komponenten der Speichereinrichtung anpaßbar ist.

4. Speichereinrichtung nach Anspruch 1,
**dadurch gekennzeichnet,**
**daß** die miteinander kooperierenden Decodier-Einheiten über eine Leitung miteinander verbunden sind, und daß der Leseverstärker einen oder mehrere Transistoren (T111, T112, T114, T115) aufweist, über welche diese Leitung mit einem oder beiden Polen einer Spannungsquelle verbunden ist.
